# EUROPÄISCHE PATENTSCHRIFT

(11) **EP 0 898 504 B1**
(45) Veröffentlichungstag und Bekanntmachung des Hinweises auf die Patenterteilung: **09.10.2002**
(21) Anmeldenummer: 98905280.8
(22) Anmeldetag: 10.01.1998
(51) Int. Cl.: B24D 11/00, B24B 13/01, B24D 18/00, B24D 3/14

(54) **SCHLEIFKÖRPER**
ABRASIVE BODY
CORPS ABRASIF

(30) Priorität: 13.01.1997 DE 29700388 U; 25.06.1997 DE 29711063 U
(43) Veröffentlichungstag der Anmeldung: 03.03.1999
(73) Patentinhaber: WINTER CVD-TECHNIK GMBH, 22609 Hamburg (DE)
(72) Erfinder: WINTER, Ernst, Michael, D-22609 Hamburg (DE); WIEMANN, Hans-Joachim, D-22339 Hamburg (DE)
(74) Vertreter: Liebelt, Rolf, Dipl.-Ing.
(86) Internationale Anmeldenummer: EP9800107
(87) Internationale Veröffentlichungsnummer: WO98030360

(56) Entgegenhaltungen:
- EP-A- 0 439 956
- EP-A- 0 445 568
- US-A- 5 358 741
- PATENT ABSTRACTS OF JAPAN vol. 012, no. 400 (M-756), 24.Oktober 1988 & JP 63 144968 A (DISCO ABRASIVE SYST LTD), 17.Juni 1988,

## Beschreibung

Die Erfindung betrifft einen Schleifkörper zum Schleifen von optischen Gläsern, Edelsteinen, Marmor oder anderen Werkststoffen wie Holz, Metall, Kunststoff oder dgl.. Insbesondere betrifft die Erfindung Schleifkörper in Form eines mit einem Schleifmaterial bestückten duktilen Grundkörpers zum Schleifen von optischen, insbesondere Brillengläsern gemäss dem Oberbegriff des Anspruchs 1. Es wird daher im folgenden überwiegend von Brillengläsern gesprochen, ohne daß damit eine Beschränkung für den Einsatz der Schleifkörper verbunden ist.

Zum Schleifen von optischen Gläsern werden mit Diamantpartikeln versehene Metallfolien von 0,1 bis 0,5 mm Stärke verwendet. Diese Metallfolien bestehen in der Regel aus einer niedrig legierten Bronze mit einem Zinngehalt von unter 10 %. Solche Folien sind folglich duktil und passen sich durch einfaches Anpressen dem gegebenen Aufnahmeradius der optischen Feinschleifmaschine an. Diese Folien können beidseitig als Schleifkörper benutzt werden, da sie in entsprechender Konzentration völlig mit Diamant durchsetzt sind. Die Diamantpartikel haben dabei eine Korngröße von vorzugsweise 5 bis 30 µm. Während des Schleifvorganges nutzen sich die Schleifkörper ab, und es entsteht als Schleifrückstand ein Gemisch aus Glasstaub, Schwermetallpulver und Diamantpulver. Es ist offensichtlich, daß die Entsorgung eines derartigen Rückstandes, insbesondere wegen des Schwermetalls, erhebliche Probleme bereitet.

JP-A- 63 144 968, das den nächstkommenden Stand der Technik beschreibt, offenbart eine Schleifscheibe mit einem duktilen Grundkörper aus einem mit Metall beschichteten Kohlenfasergewebe, worauf Diamant und Bornitridpartikeln in einer Metallschicht eingebettet sind.

Der Erfindung liegt die Aufgabe zugrunde, einen Schleifkörper zu den oben genannten Zwecken so auszubilden, daß das Problem der Entsorgung vermieden wird.

Die Aufgabe wird gemäß der Erfindung dadurch gelöst, daß der Grundkörper des Schleifkörpers aus einem Kohlefasergewebe, -gestrick oder -gewirke oder einer Graphitfolie besteht, worauf eine homogene Diamant- oder Bornitridbeschichtung als Schleifschicht niedergeschlagen ist. Dies hat den Vorteil, daß als Schleifrückstand lediglich Diamantpulver, Kohle- bzw. Graphitstaub und Staub aus dem Material des zu schleifenden Gegenstandes, z. B. Glasstaub, entsteht, der umweltfreundlich entsorgt werden kann. Ein Recycling des Glasstaubes zusammen mit dem Diamantpulver sowie Kohle-und Graphitstaub ist ohne weiteres möglich. Die unter Verwendung der erfindungsgemäßen Grundkörper, die die gleiche Stärke von 0,1 bis 0,5 mm wie die üblichen Bronzefolien aufweisen können, hergestellten Schleifkörper bieten den weiteren Vorteil, daß sie ohne weiteres als Austauschprodukte für die bekannten metallischen Schleifkörper eingesetzt werden können. Die Kohlefasergewebe, -gestricke oder -gewirke bzw. die Graphitfolien sind in gleicher Weise elastisch wie Metallfolien, da sich die Diamant- oder Bornitridschicht nur auf den Fasern des Gewebes, Gestrickes oder Gewirkes bzw. der Oberfläche der Graphitfolie niederschlägt und somit entsprechend verformen läßt.

Die Diamant- oder Bornitridbeschichtung wird vorzugsweise durch Gasphasenabscheidung, gegebenenfalls beidseitig, auf den Grundkörper aufgebracht. Durch dieses auch als CVD (Chemical Vapor Deposition) bekannte Verfahren kann eine sehr dünne und homogene Schicht erzeugt werden. Die Beschichtung kann auch durch galvanische Abscheidung zweckmäßigerweise im Wirbelbad auf dem Grundkörper niedergeschlagen werden. Es kann beispielsweise vorgesehen werden, daß die Beschichtung einseitig oder beidseitig eine Dicke von 5 bis 50 µm aufweist.

Zur Verbesserung der Haftung der Diamant- oder Bornitridbeschichtung am Werkstoff des Grundkörpers kann weiter eine vorzugsweise galvanisch aufgetragene Zwischenschicht aus Edelmetall, beispielsweise aus Gold, Silber, Platin oder Iridium, zwischen Grundkörper und Diamant'beschichtung vorgesehen sein.

Die Form der Schleifkörper ist grundsätzlich beliebig und hängt im wesentlichen von der Form der Aufnahme der Bearbeitungsmaschine für den Schleifkörper sowie dem zu bearbeitenden Werkstück ab. So kann der Schleifkörper zum Bearbeiten von Edelsteinen oder Marmor ein Ring sein.

Die Grundkörper der Schleifkörper können aus handelsüblichen Kohlefasergeweben, -gestricken oder -gewirken oder gewalzter Graphitfolie in jeder beliebigen Form den jeweiligen Bedürfnissen entsprechend hergestellt werden. Mindestens eine Fläche des fertigen Grundkörpers wird dann, beispielsweise im CVD-Verfahren, mit einer dünnen Diamant- oder Bornitridschicht versehen, wobei vor dem Auftragen der Diamant- oder Bornitridschicht auf der Fläche des Grundkörpers, welche die Diamant- oder Bornitridschicht tragen soll, noch galvanisch eine Edelmetallschicht als Haftvermittler und zum Spannungsausgleich zwischen Grundkörper und Diamantschicht aufgebracht werden kann. Die beschichteten Schleifkörper werden in üblicher Weise auf dem Schleifteller befestigt, z. B. geklebt. Die beschichteten Schleifkörper können aber auch ohne Befestigung auf einem Tragkörper, z. B. Schleifteller, wie ein Schleifpapier eingesetzt werden.

Während des Schleifvorganges nutzt sich die dünne Diamantbeschichtung in bekannter Weise ab, so daß der Grundkörper freigelegt wird. Danach kann das Werkstück nicht mehr geschliffen werden, wodurch auch der Verschleiß des Schleifkörpers ersichtlich ist. Die Schleifkörper müssen dann ausgetauscht werden. Das Abfallprodukt, der verbrauchte Schleifkörper besteht dann nur noch aus Graphitfolie oder Kohlefasern und kann ohne weiteres mit dem normalen Müll beseitigt werden. Es entfällt somit nicht nur die aufwendige Schwermetallentsorgung der bekannten Schleifkörper aus Metallfolie. Es sind auch keine umweltbelastenden chemischen Entsorgungsprozesse erforderlich. Die gebrauchten Grundkörper können auch wiederholt beschichtet werden. Abfallprodukte in einer Menge, wie sie nach dem Stand der Technik angefallen sind, werden daher vermieden.

Ausführungsbeispiele der Erfindung werden im folgenden noch anhand der schematischen Zeichnungen näher erläutert.

Es zeigen:
- Fig. 1:: im Schnitt einen Schleifkörper,
- Fig. 2:: im Schnitt eine Schleifscheibe mit einem ringförmigen Schleifkörper,
- Fig. 3:: im Schnitt eine Schleifrolle mit einem auf ihrer Mantelfläche angebrachten Schleifkörper.

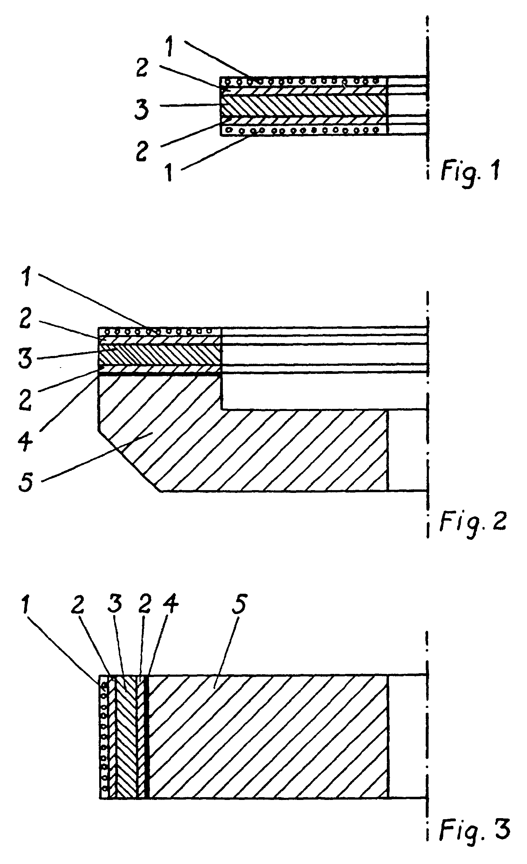

Der in Fig. 1 dargestellte Schleifkörper weist einen Grundkörper 3 aus einem Kohlefasergewebe, -gestrick oder -gewirke oder einer Graphitfolie auf. Der Grundkörper 3 ist beidseitig im CVD-Verfahren mit einer dünnen Diamantschicht 1 versehen worden. Zwischen der Diamantschicht 1 und dem Grundkörper 3 ist noch eine Edelmetallzwischenlage 2 als Haftvermittler vorgesehen. Diese Schleifkörper können auf einem nicht gezeigten Tragkörper, z. B. einem Schleifteller für optische Gläser, befestigt werden oder aber auch wie ein übliches Schleifpapier eingesetzt werden.

Bei der in Fig. 2 dargestellten und vorzugsweise zum Bearbeiten von Edelsteinen bestimmten Schleifscheibe ist am Rand eines an einer drehbaren Spindel (nicht gezeigt) gehaltenen Metalltellers 5 ein ringförmiger Schleifkörper über eine Klebschicht 4 befestigt. Der Schleifkörper umfaßt einen inneren Grundkörper 3 aus Kohlefasergewebe, -gestrick oder -gewirke oder Graphitfolie, auf dem beidseitig eine Edelmetallzwischenlage 2 galvanisch abgeschieden ist. Die vom Metallteller 5 wegweisende Fläche des Grundkörpers 3 trägt eine nach dem CVD-Verfahren aufgebrachte Diamantbeschichtung 1.

Die Fig. 3 zeigt eine metallische Schleifrolle 5, deren Mantelfläche eine Klebschicht 4 trägt, auf der ein erfindungsgemäßer Schleifkörper gehalten ist. Der Schleifkörper selbst besteht aus einem Grundkörper 3, aus einem Kohlefasergewebe, -gestrick oder -gewirke oder einer Graphitfolie und ist galvanisch mit einer Edelmetallzwischenlage 2 beschichtet worden. Die von der metallischen Schleifrolle 5 wegweisende Fläche des Grundkörpers 3 trägt eine nach dem CVD-Verfahren aufgetragene Bornitritschicht 1.

Die Erfindung ist nicht auf die dargestellten und beschriebenen Ausführungsformen begrenzt. Sie schließt für den Fachmann geläufige Abwandlungen ein. So können insbesondere mehrere ringförmige Schleifkörper, zwischen denen Diamantimprägnierungen vorgesehen sind, auf einer Schleifscheibe angeordnet sein. Es kann auch der Randbereich der Schleifscheibe die Diamantimprägnierung aufweisen, an die zur Scheibenmitte hin ringförmige Schleifkörper angrenzen. Die ringförmigen Schleifkörper können auch am Rand von topfförmigen Schleiftellern oder Schleifscheiben gehalten sein, wobei die die Diamantbeschichtung tragende Fläche der Schleifkörper gekrümmt sein kann.

## Patentansprüche

1. Schleifkörper zum Schleifen von optischen Gläsern, Edelsteinen, Marmor oder anderen Werkstoffen wie Holz, Metall, Kunststoff oder dgl. in Form eines mit einem Schleifmaterial bestückten duktilen Grundkörpers, **dadurch gekennzeichnet daß** der Grundkörper (3) aus einem Kohlenfasergewebe, -gestrick oder -gewirke oder einer Graphitfolie besteht, worauf eine homogene Diamant- oder Bornitridbeschichtung (1) als Schleifschicht niedergeschlagen ist.

2. Schleifkörper nach Anspruch 1, **dadurch gekennzeichnet, daß** die Diamant- oder Bornitridbeschichtung (1) durch Gasphasenabscheidung auf den Grundkörper (3) aufgebracht wird.

3. Schleifkörper nach Anspruch 1, **dadurch gekennzeichnet, daß** die Diamant- oder Bornitridbeschichtung (1) durch galvanische Abscheidung an den Grundkörper (3) aufgebracht wird.

4. Schleifkörper nach einem der Ansprüche 1 bis 3, **dadurch gekennzeichnet, daß** die Diamant- oder Bornitridbeschichtung (1) eine Dicke von 5 bis 50 µm aufweist.

5. Schleifkörper nach einem der Ansprüche 1 bis 4, **dadurch gekennzeichnet, daß** zwischen dem Grundkörper (3) und der Diamant- bzw. Bornitridbeschichtung (1) eine Zwischenschicht (2) aus Edelmetall wie Gold, Silber, Platin, Iridium oder anderen Edelmetallen vorgesehen ist.

6. Schleifkörper nach Anspruch 5, **dadurch gekennzeichnet, daß** eine Zwischenschicht (2) aus Edelmetall galvanisch auf den Grundkörper (3) aufgetragen wird.

## Claims

1. Abrasive body for grinding optical lenses, precious stones, marble or other materials such as wood, metal, plastics material or the like in the form of a ductile base body equipped with an abrasive material, **characterised in that** the base body (3) consists of a carbon fibre woven fabric, knitted fabric or a graphite foil, on which a homogenous diamond or boron nitride coating (1) has been deposited as an abrasive layer.

2. Abrasive body according to claim 1, **characterised in that** the diamond or boron nitride coating (1) is applied to the base body (3) by a chemical vapour deposition.

3. Abrasive body according to claim 1, **characterised in that** the diamond or boron nitride coating (1) is applied to the base body (3) by electroplating.

4. Abrasive body according to any one of claims 1 to 3, **characterised in that** the diamond or boron nitride coating (1) has a thickness of 5 to 50 µm.

5. Abrasive body according to any one of claims 1 to 4, **characterised in that** an intermediate layer (2) made of precious metal such as gold, silver, platinum, iridium or other precious metals is provided between the base body (3) and the diamond or boron nitride coating (1).

6. Abrasive body according to claim 5, **characterised in that** an intermediate layer (2) made of precious metal is applied to the base body (3) by electroplating.

## Revendications

1. Corps abrasif pour polir des verres optiques, des pierres précieuses, du marbre ou d'autres matériaux comme le bois, le métal, la matière plastique ou analogues, se présentant sous la forme d'un substrat ductile doté d'un matériau abrasif, **caractérisé en ce que** le substrat (3) se compose d'un tissu ou d'un tricot de fibres de verre, ou d'une feuille de fibres de carbone, sur lequel un revêtement (1) de diamant ou de nitrure de bore est déposé sous la forme d'une couche abrasive.

2. Corps abrasif selon la revendication 1, **caractérisé en ce que** le revêtement (1) de diamant ou de nitrure de bore est déposé sur le substrat (3) par un procédé de déposition en phase gazeuse.

3. Corps abrasif selon la revendication 1, **caractérisé en ce que** le revêtement (1) de diamant ou de nitrure de bore est déposé sur le substrat (3) par un procédé de déposition galvanique.

4. Corps abrasif selon l'une des revendications 1 à 3, **caractérisé en ce que** le revêtement (1) de diamant ou de nitrure de bore a une épaisseur allant de 5 à 50 µm.

5. Corps abrasif selon l'une des revendications 1 à 4, **caractérisé en ce qu'**il est prévu une couche intermédiaire (2) de métal précieux, comme l'or, l'argent, le platine, l'iridium ou d'autres métaux précieux, entre le substrat (3) et le revêtement (1) de diamant ou de nitrure de bore.

6. Corps abrasif selon la revendication 5, **caractérisé en ce qu'**une couche intermédiaire (2) de métal précieux est déposée sur le substrat par un procédé galvanique.
